# EUROPÄISCHE PATENTSCHRIFT

(11) **EP 1 829 084 B1**
(45) Veröffentlichungstag und Bekanntmachung des Hinweises auf die Patenterteilung: **25.07.2012**
(21) Anmeldenummer: 05811027.1
(22) Anmeldetag: 03.11.2005
(51) Int. Cl.: H01L 21/00, H01L 21/68, B05B 13/02, B08B 3/02

(54) **DREHBARE VORRICHTUNG ZUM HALTEN EINES SUBSTRATS**
ROTATABLE DEVICE FOR HOLDING A SUBSTRATE
DISPOSITIF ROTATIF POUR MAINTENIR UN SUBSTRAT

(30) Priorität: 03.11.2004 DE 102004053139
(43) Veröffentlichungstag der Anmeldung: 05.09.2007
(73) Patentinhaber: Süss MicroTec Lithography GmbH, 85748 Garching (DE)
(72) Erfinder: FISCHER, Karin, 85748 Garching (DE); KRAMER, Joseph, 85748 Garching (DE)
(74) Vertreter: Heunemann, Dieter
(86) Internationale Anmeldenummer: PCT/EP2005/011776
(87) Internationale Veröffentlichungsnummer: WO 2006/048287

(56) Entgegenhaltungen:
- US-A- 5 349 978
- PATENT ABSTRACTS OF JAPAN Bd. 018, Nr. 573 (E-1624), 2. November 1994 (1994-11-02) & JP 06 216018 A (TOKYO ELECTRON LTD; others: 01), 5. August 1994 (1994-08-05)
- PATENT ABSTRACTS OF JAPAN Bd. 016, Nr. 008 (E-1152), 10. Januar 1992 (1992-01-10) & JP 03 230518 A (NEC CORP), 14. Oktober 1991 (1991-10-14)
- PATENT ABSTRACTS OF JAPAN Bd. 2003, Nr. 12, 5. Dezember 2003 (2003-12-05) & JP 2004 087934 A (NEC CORP), 18. März 2004 (2004-03-18)

## Beschreibung

Die vorliegende Erfindung betrifft eine dreh- und gegebenenfalls heizbare Vorrichtung bzw. einen Chuck zum Halten eines Substrats.

Zum Halten bzw. Fixieren flächiger Substrate werden im Rahmen der Fertigung von Halbleiterbauelementen oder bei der Herstellung optischer Datenträger üblicherweise sogenannte Chucks verwendet. Solche Chucks weisen eine Auflagefläche für die Substrate auf, auf der durch speziell angeordnete Vakuumkanäle das Substrat angesaugt und festgehalten wird. Zum Heizen des Substrats ist es bekannt, den Chuck mittels einer Heizeinrichtung und somit das auf dem Chuck aufliegende Substrat aufzuheizen bzw. zu erwärmen. Eine Anwendung, bei der heizbare Chucks verwendet werden, ist das Oberflächenbeschichten von Substraten durch Spraycoating, wie es in der Fertigung von Halbleitern oder optischen Datenträgern angewendet wird. Zur Verbesserung der Kantenbedeckung wird beim Spraycoaten das Substrat erhitzt.

Da die in direktem Kontakt zur Substratoberfläche befindliche Auflagefläche des Chucks gewöhnlich kleiner als die Fläche des Substrats ist, besteht die Gefahr, dass während der Behandlung des auf der Auflagefläche des Substrats aufliegenden Substrats die der Auflagefläche des Chucks zugewandte, radial nach außen überstehende Fläche des Substrats kontaminiert wird. So kann beim Spraycoating beispielsweise ein Teil des Lacks, der auf die der Auflagefläche abgewandten Seite des Substrats aufgebracht werden soll, über die Außenkante auf die Rückseite, also auf die vom Chuck radial nach außen überstehende, freiliegende, der Auflagefläche zugewandten Seite des Substrats gelangen. Um derartige Kontaminationen zu entfernen, wird die kontaminierte Oberfläche des Substrats im Anschluss an die vorstehend erklärte Behandlung (z. B. Spraycoating) gereinigt, beispielsweise mit einem Lösungsmittel behandelt. Dies geschieht in einer eigens dafür vorgesehenen Anlage. Um die gesamte kontaminierte Fläche des Wafers reinigen zu können, insbesondere also auch Kontaminationen im Randbereich des Substrats entfernen zu können, muss entweder eine Düse, die das Lösungsmittel auf den Wafer aufbringt, über die gesamte kontaminierte Fläche des Substrats geführt werden, während der Wafer statisch auf einem dafür vorgesehenen Chuck ruht; alternativ kann der Wafer in diesem Reinigungsschritt von einem drehbaren Chuck gehalten, gedreht und von einer feststehenden Düse besprüht werden. Durch die Drehung bzw. Rotation des Substrats gelangt das Lösungsmittel auch in den Randbereich des Substrats.

In dem bekannten Verfahren wird also die jeweilige Behandlung des Substrats, z. B. Beschichten durch Spraycoating, mit oder ohne Heizen des Substrats, und der notwendige Reinigungsvorgang nacheinander auf unabhängigen Vorrichtungen durchgeführt. Dies bedeutet aber, dass das Substrat nach der Behandlung, beispielsweise nach dem Beschichten durch Spraycoating, auf eine andere Vorrichtung transportiert werden muss. Dies birgt die Gefahr einer weiteren Kontamination oder einer Beschädigung des Substrats. Ferner ist dieses herkömmliche Verfahren zeit- und damit kostenintensiv. Darüber hinaus entstehen durch das Erfordernis zweier getrennter Behandlungsvorrichtungen weitere Kosten.

Die US 5 349 978 A offenbart eine Vorrichtung zum Halten und Drehen eines flächigen Substrats, insbesondere zum Behandeln der freien Oberfläche des Substrats durch Schleuderbeschichtung mit einer um eine Achse drehbaren Auflageeinrichtung zum Auflegen und Halten des Substrats auf einer zur Achse senkrechten Auflagefläche. Der Durchmesser der Auflagefläche ist kleiner als der des Substrats. Ferner sind eine Dreheinrichtung zum Drehen der Auflageeinrichtung und eine Fluidzufuhranordnung zum Zuführen eines Fluids auf den über die Auflagefläche radial nach außen überstehenden Teil der der Auflagefläche zugewandten Seite des Substrats vorgesehen.

Ähnliche Vorrichtungen sind aus der JP 06 216018 A und der JP 03 230518 A bekannt.

Es ist daher Aufgabe der vorliegenden Erfindung, eine verbesserte Haltevorrichtung für Substrate bereitzustellen, die die oben genannten Probleme löst. Insbesondere soll eine Haltevorrichtung bereitgestellt werden, die es ermöglicht, sowohl eine Behandlung eines auf einer Haltefläche aufliegenden Substrats, als auch die anschließend gegebenenfalls notwendige Reinigung durchzuführen.

Diese Aufgabe wird mit den Merkmalen der Patentansprüche 1 und 3 gelöst.

Die vorliegende Erfindung geht von dem Grundgedanken aus, das auf der drehbaren Haltevorrichtung aufliegende Substrat auf seiner der Auflagefläche der Haltevorrichtung zugewandten Seite mit Hilfe eines auf diese Seite aufgetragenen Fluids zu behandeln, insbesondere zu reinigen.

Darüber hinaus wird erfindungsgemäß eine Haltevorrichtung für flächige Substrate bereitgestellt, die sowohl heizbar als auch drehbar ist, um die Substrate bei der Behandlung in Drehbewegung zu versetzen.

Die Vorrichtung gemäß der Erfindung weist eine Auflageeinrichtung zum Auflegen und Halten des flächigen Substrats auf einer Auflagefläche auf. Dies kann beispielsweise, wie oben beschrieben, mit Hilfe von Vakuumkanälen in der Auflagefläche geschehen, über die das Substrat angesaugt und somit festgehalten wird. Die erfindungsgemäße Vorrichtung weist bevorzugt eine Einrichtung zum Heizen des Substrats auf. Diese Heizeinrichtung wird für den Heizvorgang mit der Rückseite der Auflagefläche in Verbindung gebracht, auf der das Substrat aufliegt, um so durch den Kontakt zwischen der aufgeheizten Auflagefläche und dem Substrat das Substrat erwärmen zu können. Darüber hinaus weist die erfindungsgemäße Vorrichtung eine Einrichtung zum Drehen der Halteeinrichtung auf. Um die Halte- und Auflageeinrichtung unabhängig von der Heizeinrichtung drehen zu können, wird zum Drehen die Auflageeinrichtung von der Heizeinrichtung z. B. durch axialen Versatz getrennt. Das Heizen der Auflageeinrichtung durch die Heizeinrichtung und das Drehen des Substrats erfolgt also nicht gleichzeitig.

Über eine Fluidzufuhranordung wird während der Drehung der Auflageeinrichtung mit dem Substrat ein Fluid, z. B. ein Lösungsmittel auf die der Auflagefläche der Auflageeinrichtung zugewandten Seite des Substrats aufgebracht. Durch die Rotation wird das Fluid oder Lösungsmittel verteilt und erreicht auch den Randbereich des Substrats.

Das Fluid oder Lösungsmittel wird vorzugsweise über eine Düse in eine zur Drehachse der Vorrichtung koaxiale Nut in der Auflageeinrichtung eingeleitet; diese Nut steht über ein Kanalsystem mit Bohrungen und Öffnungen im Randbereich der Auflageeinrichtung in Verbindung, so dass das Fluid gegen die über die Auflagefläche radial überstehende, der Auflagefläche zugewandten Seite des Substrats auf das Substrat verteilt werden kann. Hierzu ist vorzugsweise der Randbereich der Auflagefläche, in dem die Öffnungen angeordnet sind, leicht abgesenkt. Alternativ kann die Fluidzuführanordnung auch als ein externer Sprühkopf ausgebildet sein. Dieser kann im Bedarfsfall unter den Randbereich des Substrats eingefahren werden und so das Fluid oder Lösungsmittel auf die über die Auflagefläche radial überstehende, der Auflagefläche zugewandten Seite des Substrats auf das Substrat verteilen.

Zum Halten eines 6-Zoll Substrats hat die Auflagefläche einen Durchmesser von typisch etwa 143 mm. Ein radial anschließender Randbereich von etwa 5 mm ist um etwa 0,2 mm abgesenkt. In diesem Randbereich befinden sich die Öffnungen der Bohrungen zum Aufsprühen des Lösungsmittels auf einem Kreis mit einem Durchmesser von beispielsweise etwa 144 mm. Die Auflageeinrichtung zum Auflegen und Halten des Substrats ist vorzugsweise aus einem Metall oder einer Metalllegierung und besonders bevorzugt aus Aluminium gefertigt.

Um die der Auflagefläche der Auflageeinrichtung zugewandten Seite des Substrats zusätzlich während dem Sprühbeschichten zu schützen, kann die Auflageeinrichtung derart ausgeführt sein, dass das Substrat während dem Sprühbeschichten vollständig auf der Auflagefläche aufliegt. Hierzu ist zusätzlich zu dem Zentralbereich der Auflageeinrichtung ein Randbereich vorgesehen, der mit dem Zentralbereich bündig abschließt. Um den Randbereich des Substrats von Sprühlack reinigen zu können, der gegebenenfalls dennoch im Randbereich auf die der Auflagefläche zugewandten Seite des Substrats gelangt ist, ist der Zentralbereich der Auflageeinrichtung gegenüber dem Randbereich koaxial verschiebbar, so dass im verschobenen Zustand im Randbereich des Substrats auch die der Auflageeinrichtung zugewandte Seite freigelegt wird. Zum Reinigen der der Auflagefläche zugewandten Seite des Substrats wird mittels einer Fluidzuführanordnung, wie oben beschrieben, ein Fluid bzw. ein Lösungsmittel aufgesprüht.

Die Erfindung wird nachstehend anhand eines Ausführungsbeispiels unter Bezugnahme auf die Zeichnungen näher erläutert. Es zeigen:
- Fig.1: eine schematische Querschnittskizze eines dreh- und heizbaren Chucks gemäß der Erfindung,
- Fig. 2: einen vergrößerten Ausschnitt B aus Fig. 1 und
- Fig. 3(a) bis (c): eine schematische Querschnittsskizze einer alternativen Ausführungsform eines Chucks gemäß der Erfindung.

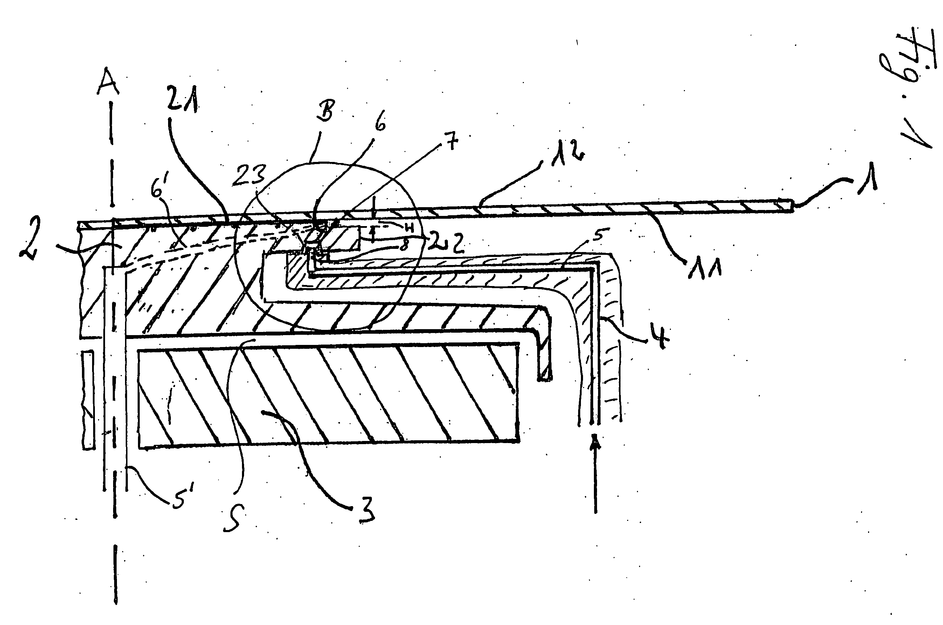

Gemäß Fig. 1 weist eine erfindungsgemäße Vorrichtung eine Auflageeinrichtung 2, z. B. einen Chuck, zum Auflegen und Halten eines Substrats 1 auf einer Auflagefläche 21 auf. Die Auflageeinrichtung 2 kann mittels einer Heizeinrichtung 3 zum Heizen erwärmt werden, um das aufliegende Substrat 1 zu erwärmen. Für den Heizvorgang steht die Heizeinrichtung 3 in Kontakt mit der Auflageeinrichtung 2. Die Auflageeinrichtung 2 kann um eine Achse A gedreht werden, dies kann beispielsweise durch einen (nicht gezeigten) Motor geschehen, der die Einrichtung 2 in Rotation versetzt, ohne dabei die Heizeinrichtung 3 mitzudrehen. Zu diesem Zweck wird, wie in Figur 1 gezeigt, die Einrichtung 2 von der Heizeinrichtung 3 getrennt, indem die Einrichtung 2 etwas nach oben oder die Heizeinrichtung 3 nach unten gefahren wird, so dass ein Spalt S zwischen den beiden Einrichtungen 2 und 3 gebildet wird.

Mit Hilfe einer Fluidzuführeinrichtung 4 wird ein Fluid, d. h. ein Gas oder eine Flüssigkeit, z. B. ein Lösungsmittel, über eine Rohrleitung 5 und eine in eine zur Achse A koaxiale Ringnut 23 hineinragende Düse 8 in diese Nut 23 eingeleitet bzw. eingespritzt. Diese Ringnut 23 ist in einer Rückseite der Auflageeinrichtung 2, d. h. der Auflagefläche 21 gegenüberliegend ausgebildet. Von dieser Ringnut 23 aus erstrecken sich Bohrungen 6, die zu Öffnungen 7 in einem gegenüber der Auflagefläche 21 abgesenkten Abschnitt 22 führen. Durch die Bohrungen 6 und Öffnungen 7 wird das Fluid, z. B. ein Lösungsmittel, auf die der Auflagefläche 21 zugewandte Seite 11 des Substrats 1 geleitet soweit diese Seite 11 radial über die Auflagefläche 21 nach außen hinausragt. Durch die Drehung der Auflageeinrichtung 2 und damit durch die Drehung des Substrats 1 wird das Fluid, z. B. das Lösungsmittel, zum radial äußeren Rand der Oberfläche 11 des Substrats 1 geleitet und kann somit auch den Randbereich des Substrats 1 reinigen. Vorzugsweise ist die Auflageeinrichtung 2 so ausgeführt, dass die Teile des Fluids, die zwar durch die Düse in die Ringnut 23 eingespritzt werden, jedoch nicht durch die Bohrungen auf die Substratoberfläche 11 gelangen sondern nach unten tropfen, nicht auf die Heizeinrichtung 3 gelangen können.

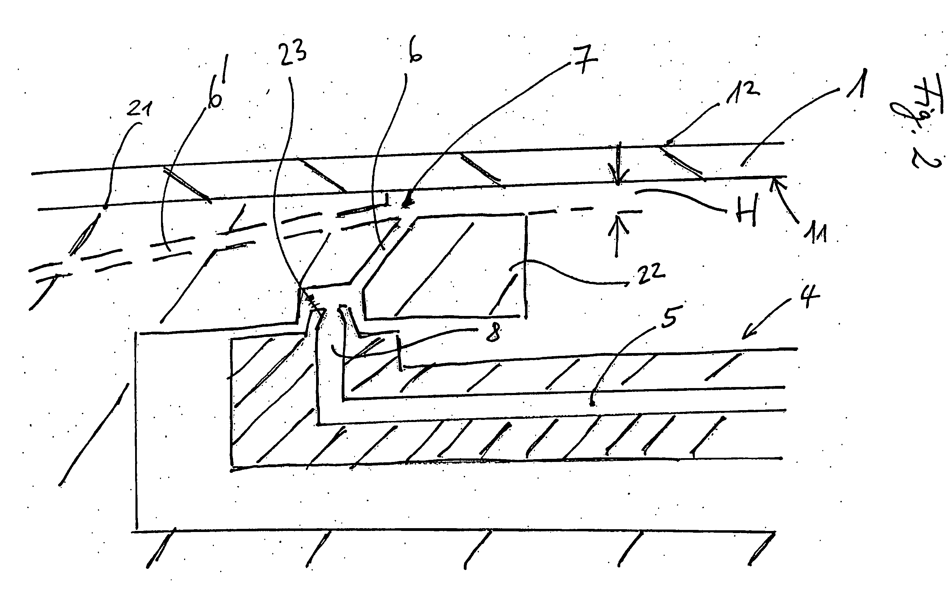

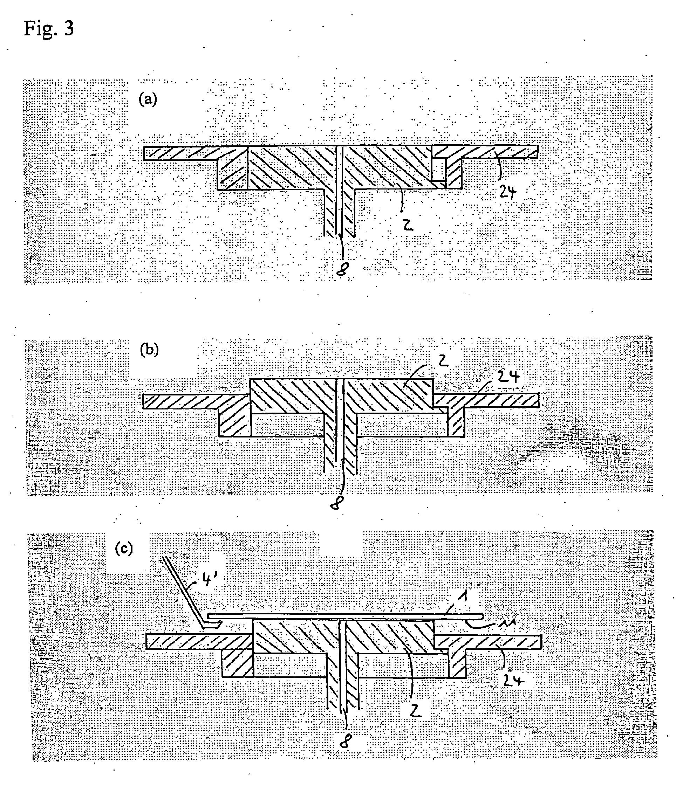

Statt über eine Ringnut 23 kann das Fluid auch beispielsweise axial durch eine in einer Axialbohrung in der Heizeinrichtung 3 geführte Rohrleitung 5' ins Innere der Auflageeinrichtung 2 und von dort über im wesentlichen radiale Bohrungen 6' zu den Öffnungen 7 in der Randstufe 22 geleitet werden, wie dies in Fig. 1 und 2 gestrichelt eingezeichnet ist. Alternativ kann die Fluidzuführeinrichtung auch als externer Sprühkopf 4' ausgebildet sein, wie es in der unten näher beschriebenen Fig. 3(c) gezeigt ist. Dieser Sprühkopf kann beweglich sein und beispielsweise nur bei Bedarf unter das Substrat eingefahren werden. Mit einem beweglichen Sprühkopf lässt sich die der Auflagefläche zugewandte Seite des Substrats abfahren und somit das Fluid gleichmäßig aufbringen.

In Fig. 3(a) bis (c) ist eine alternative Ausführungsform eines drehbaren Chucks gemäß der Erfindung schematisch dargestellt. Die in Fig. 3(a) bis (c) gezeigte Ausführungsform ist ein zweigeteilter Chuck, der zusätzlich zu einem Zentralteil 2 der Auflageeinrichtung einen Randbereich 24 aufweist. Beim Sprühbelacken wird der zweigeteilte Chuck im abgesenkten Zustand, der in Figur 3(a) gezeigt ist, verwendet. Über einen Vakuumanschluss 8 wird das Substrat auf dem Chuck wie oben beschrieben festgesaugt. In diesem Zustand schließt der Zentralbereich 2 mit dem Randbereich bündig ab, so dass sich im abgesenkten Zustand das Substrat 1 also vollflächig auf der Auflageeinrichtung 2 und 24 befindet. Somit ist die der Auflageeinrichtung zugewandte Seite des Substrats im wesentlichen vollständig verdeckt, und somit die Gefahr der Verschmutzung dieser Seite durch die aufzubringende Substanz weitgehend vermieden. Da die Verschmutzung jedoch nicht vollständig verhindert werden kann, wird nach dem Sprühvorgang der Zentralbereich des Chucks angehoben. Dadurch entsteht ein Freiraum zwischen der Oberseite des Randbereichs 24 des Chucks und der Unterseite 11 des Substrats 1, wie in Fig. 3(b) gezeigt. Auch in diesem Zustand bleibt das Substrat durch den Vakuumanschluss 8 angesaugt. Mittels einer Fluidzufuhreinrichtung, wie oben beschrieben, kann dann ein Fluid auf die nun freiliegende Unterseite 11 des Substrats 1 aufgebracht werden. In Fig. 3(c) ist beispielhaft ein Sprühkopf 4' gezeigt. Jedoch können auch in dieser alternativen Ausführungsform die oben beschriebenen Kanäle zur Zufuhr des Fluids vorgesehen sein. Auch in dieser alternativen Ausführungsform ist es möglich, den Chuck zu heizen. Je nach Bedarf kann entweder nur der Zentralteil 2 oder sowohl der Zentralteil 2 als auch der Randbereich 24 des Chucks heizbar sein.

Weiterhin wird in der vorliegenden Erfindung auch eine Kombination ohne eine Fluidzufuhranordnung beansprucht, die die oben beschriebene Dreheinrichtung in Verbindung mit der oben beschriebenen Heizeinrichtung umfasst, wobei zum Drehen die Auflageeinrichtung von der Heizeinrichtung getrennt wird.

## Patentansprüche

1. Vorrichtung zum Halten und Drehen eines flächigen Substrats (1), insbesondere zum Behandeln der freien Oberfläche des Substrats durch Schleuderbeschichtung , mit
einer um eine Achse (A) drehbaren Auflageeinrichtung (2) zum Auflegen und Halten des Substrats (1) auf einer zur Achse (A) senkrechten Auflagefläche (21), wobei der Durchmesser der Auflagefläche (21) kleiner ist als der des Substrats,
einer Dreheinrichtung zum Drehen der Auflageeinrichtung (2),
einer Fluidzufuhranordung (4) zum Zuführen eines Fluids auf den über die Auflagefläche (21) radial nach außen überstehenden Teil der der Auflagefläche (21) zugewandten Seite (11) des Substrats (1), und characterisiert durch
einen zur Auflageeinrichtung (2) koaxialen Randbereich (24) der relativ zur Auflageeinrichtung zwischen einer ersten Position, in der die dem Substrat zugewandten Seiten des Randbereichs (24) und der Auflageeinrichtung (2) zueinander bündig sind (Fig. 3a), und einer zweiten Position axial verschiebbar ist, in der die dem Substrat zugewandte Seite des Randbereichs (24) gegenüber dem Substrat beabstandet ist (Fig. 3b und 3c).

2. Vorrichtung nach Ansprüch 1, wobei die Fluidzufuhranordung (4) in der der Auflagefläche (21) abgewandten Seite der Auflageeinrichtung (2) eine zur Achse (A) koaxiale Ringnut (23) zum Einleiten von Fluid über eine Zufuhrleitung (5) aufweist, die durch im wesentlichen radiale Bohrungen (6) mit Öffnungen (7) in der Auflagefläche (21) in Verbindung steht.

3. Vorrichtung zum Halten und Drehen eines flächigen Substrats (1), insbesondere zum Behandeln der freien Oberfläche des Substrats durch Schleuderbeschichtung mit
einer um eine Achse (A) drehbaren Auflageeinrichtung (2) zum Auflegen und Halten des Substrats (1) auf einer zur Achse (A) senkrechten Auflagefläche (21), wobei der Durchmesser der Auflagefläche (21) kleiner ist als der des Substrats,
einer Dreheinrichtung zum Drehen der Auflageeinrichtung (2) und
einer Fluidzufuhranordung (4) zum Zuführen eines Fluids auf den über die Auflagefläche (21) radial nach außen überstehenden Teil der der Auflagefläche (21) zugewandten Seite (11) des Substrats (1),
characterisiert, indem die Fluidzufuhranordung (4) in der der Auflagefläche (21) abgewandten Seite der Auflageeinrichtung (2) eine zur Achse (A) koaxiale Ringnut (23) zum Einleiten von Fluid über eine Zufuhrleitung (5) aufweist, die durch im wesentlichen radiale Bohrungen (6) mit Öffnungen (7) in der Auflagefläche (21) in Verbindung steht.

4. Vorrichtung nach Anspruch 2 oder 3 , wobei am Umfang der Auflagefläche (21) ein gegenüber der Auflagefläche (21) abgestufter Rand (22) vorgesehen ist und die Öffnungen (7) im Bereich der Randstufe ausgebildet sind.

5. Vorrichtung nach einemder Ansprüche 1 bis 4, wobei die Fluidzufuhranordnung während der Drehung der Auflageeinrichtung (2) aktivierbar ist.

6. Vorrichtung nach einem der Ansprüche 1 bis 5, mit einer Einrichtung (3) zum Heizen der Auflageeinrichtung (2).

7. Vorrichtung nach Anspruch 6, wobei die Heizeinrichtung (3) mit der Auflageeinrichtung (2) in Kontakt bringbar ist, wenn die Auflageeinrichtung (2) nicht gedreht wird.

8. Vorrichtung nach Anspruch 6 oder 7, wobei die Heizeinrichtung (3) und die Auflageeinrichtung (2) koaxial angeordnet sind.

9. Vorrichtung nach Anspruch 8, wobei die Heizeinrichtung (3) zum Heizen der Auflageeinrichtung (2) über die Kontaktfläche axial verschiebbar ist.

10. Vorrichtung nach einem der Ansprüche 1 bis 9, wobei die Fluidzufuhranordnung in Form eines beweglichen Sprühkopfs (4') ausgebildet ist.

11. Vorrichtung nach einem der Anspruch, 1 bis 10, wobei die Höhe (H) der Randstufe etwa 0,2 mm beträgt.

12. Vorrichtung nach einem der Ansprüche 1 bis 11, wobei die Breite des abgestuften Randes (22) in Radialrichtung etwa 3 mm bis 10 mm, vorzugsweise 5 mm beträgt.

13. Vorrichtung nach einem der Ansprüche 6 bis 12, wobei die Heizeinrichtung (3) einen Widerstandsheizer aufweist.

14. Vorrichtung nach einem der vorstehenden Ansprüche, wobei die Auflageeinrichtung (2) aus einem Metall, vorzugsweise aus Aluminium hergestellt ist.

15. Vorrichtung nach einem der vorstehenden Ansprüche, wobei der Radius der Auflagefläche (21) etwa 100 mm bis etwa 200 mm beträgt.

## Claims

1. A device for holding and rotating a flat substrate (1), in particular for treating the exposed surface of the substrate by spray coating, comprising
a supporting means (2) which can be rotated around an axis (A) and serves for placing and holding the substrate (1) on a supporting surface (21) extending perpendicularly with respect to the axis (A), wherein the diameter of the supporting surface (21) is smaller than that of the substrate,
a rotating means for rotating the supporting means (2),
a fluid supply arrangement (4) for supplying a fluid onto the part of the side (11) of the substrate (1) facing the supporting surface (21) and radially projecting outwardly from the supporting surface (21), and **characterised by**
an edge region (24) which is coaxial with respect to the supporting means (2) and which is axially movable relative to the supporting means between a first position in which the sides of the edge region (24) and of the supporting means (2) facing the substrate are flush (Fig. 3a) and a second position in which the side of the edge region (24) facing the substrate is spaced apart from the substrate (Figs. 3b and 3c).

2. The device according to claim 1, wherein the fluid supply arrangement (4) comprises, in the side of the supporting means (2) facing away from the supporting surface (21), an annular groove (23) which is coaxial with respect to the axis (A), serves for introducing fluid through a supply line (5) and communicates with openings (7) in the supporting surface (21) through essentially radial bores (6).

3. A device for holding and rotating a flat substrate (1), in particular for treating the exposed surface of the substrate by spray coating, comprising
a supporting means (2) which can be rotated around an axis (A) and serves for placing and holding the substrate (1) on a supporting surface (21) extending perpendicularly with respect to the axis (A), wherein the diameter of the supporting surface (21) is smaller than that of the substrate,
a rotating means for rotating the supporting means (2), and
a fluid supply arrangement (4) for supplying a fluid onto the part of the side (11) of the substrate (1) facing the supporting surface (21) and radially projecting outwardly from the supporting surface (21), **characterised in that**
the fluid supply arrangement (4) comprises, in the side of the supporting means (2) facing away from the supporting surface (21), an annular groove (23) which is coaxial with respect to the axis (A), serves for introducing fluid through a supply line (5) and communicates with openings (7) in the supporting surface (21) through essentially radial bores (6).

4. The device according to claim 2 or 3, wherein an edge (22) that is stepped relative to the supporting surface (21) is provided at the circumference of the supporting surface (21) and the openings (7) are formed in the region of the edge step.

5. The device according to any one of claims 1 to 4, wherein the fluid supply arrangement can be activated during the rotation of the supporting means (2).

6. The device according to any one of claims 1 to 5 comprising a means (3) for heating the supporting means (2).

7. The device according to claim 6, wherein the heater (3) can be brought in contact with the supporting means (2) if the supporting means (2) is not rotated.

8. The device according to claim 6 or 7, wherein the heater (3) and the supporting means (2) are arranged coaxially.

9. The device according to claim 8, wherein the heater (3) is axially movable for heating the supporting means (2) via the contact surface.

10. The device according to any one of claims 1 to 9, wherein the fluid supply arrangement is realised as a movable spray head (4').

11. The device according to any one of claims 1 to 10, wherein the height (H) of the edge step is approximately 0.2 mm.

12. The device according to any one of claims 1 to 11, wherein the width of the stepped edge (22) is approximately 3 mm to 10 mm, preferably 5 mm, in the radial direction.

13. The device according to any one of claims 6 to 12, wherein the heater (3) comprises a resistance heater.

14. The device according to any one of the preceding claims, wherein the supporting means (2) is made of metal, preferably aluminium.

15. The device according to any one of the preceding claims, wherein the radius of the supporting surface (21) is approximately 100 mm to approximately 200 mm.

## Revendications

1. Système pour le maintien et la rotation d'un substrat (1) plat, en particulier pour le traitement de la surface libre du substrat par revêtement par centrifugation, comprenant
un dispositif de mise en place (2) rotatif autour d'un axe (A) pour le positionnement et le maintien du substrat (1) sur une surface d'appui (21) perpendiculaire à l'axe (A), le diamètre de la surface d'appui (21) étant inférieur à celui du substrat,
un dispositif de rotation pour mettre en rotation le dispositif de mise en place (2),
un dispositif d'amenée de fluide (4) pour amener un fluide vers la partie de la face (11) du substrat (1) opposée à la surface d'appui (21) qui dépasse radialement de la surface d'appui (21) vers l'extérieur, et **caractérisé par** une zone de bord (24) coaxiale au dispositif de mise en place (2), laquelle est axialement mobile par rapport au dispositif de mise en place entre une première position où les faces opposées au substrat de la zone de bord (24) et du dispositif de mise en place (2) sont affleurantes entre elles (fig. 3a), et une deuxième position où la face de la zone de bord (24) opposée au substrat est espacée dudit substrat (fig. 3b et 3c).

2. Système selon la revendication 1, où le dispositif d'amenée de fluide (4) comporte sur la face du dispositif de mise en place (2) qui est distante de la surface d'appui (21) une rainure annulaire (23) coaxiale à l'axe (A) pour la conduction de fluide par une conduite d'amenée (5), ladite rainure étant reliée à des alésages (6) sensiblement radiaux avec des ouvertures (7) dans la surface d'appui (21).

3. Système pour le maintien et la rotation d'un substrat (1) plat, en particulier pour le traitement de la surface libre du substrat par revêtement par centrifugation, comprenant
un dispositif de mise en place (2) rotatif autour d'un axe (A) pour le positionnement et le maintien du substrat (1) sur une surface d'appui (21) perpendiculaire à l'axe (A), le diamètre de la surface d'appui (21) étant inférieur à celui du substrat,
un dispositif de rotation pour mettre en rotation le dispositif de mise en place (2) et
un dispositif d'amenée de fluide (4) pour amener un fluide vers la partie de la face (11) du substrat (1) opposée à la surface d'appui (21) qui dépasse radialement de la surface d'appui (21) vers l'extérieur, **caractérisé en ce que** le dispositif d'amenée de fluide (4) comporte sur la face du dispositif de mise en place (2) qui est distante de la surface d'appui (21) une rainure annulaire (23) coaxiale à l'axe (A) pour la conduction de fluide par une conduite d'amenée (5), ladite rainure étant reliée à des alésages (6) sensiblement radiaux avec des ouvertures (7) dans la surface d'appui (21).

4. Système selon la revendication 2 ou la revendication 3, où, à la périphérie de la surface d'appui (21), un bord étagé (22) est prévu en opposition à la surface d'appui (21), et où les ouvertures (7) sont formées au niveau de l'étagement de bord.

5. Système selon l'une des revendications 1 à 4, où le dispositif d'amenée de fluide peut être activé pendant la rotation du dispositif de mise en place (2).

6. Système selon l'une des revendications 1 à 5, comportant un dispositif (3) de chauffage du dispositif de mise en place (2).

7. Système selon la revendication 6, où le dispositif de chauffage (3) peut être mis en contact avec le dispositif de mise en place (2) lorsque le dispositif de mise en place (2) n'est pas mis en rotation.

8. Système selon la revendication 6 ou la revendication 7, où le dispositif de chauffage (3) et le dispositif de mise en place (2) sont agencés de manière coaxiale.

9. Système selon la revendication 8, où le dispositif de chauffage (3) est axialement mobile sur la surface de contact pour le chauffage du dispositif de mise en place (2).

10. Système selon l'une des revendications 1 à 9, où le dispositif d'amenée de fluide est réalisé sous la forme d'une tête de pulvérisation (4') mobile.

11. Système selon l'une des revendications 1 à 10, où la hauteur (H) de l'étagement de bord est de 0,2 mm environ.

12. Système selon l'une des revendications 1 à 11, où la largeur du bord étagé (22) dans la direction radiale est comprise entre 3 mm et 10 mm environ, et de préférence égale à 5 mm.

13. Système selon l'une des revendications 6 à 12, où le dispositif de chauffage (3) comporte un chauffage à résistance.

14. Système selon l'une des revendications précédentes, où le dispositif de mise en place (2) est fabriqué en métal, de préférence en aluminium.

15. Système selon l'une des revendications précédentes, où le rayon de la surface d'appui (21) est compris entre 100 mm environ et 200 mm environ.
